(19) **Europäisches Patentamt / European Patent Office / Office européen des brevets**

(11) **EP 4 421 482 B1**

(12) **FASCICULE DE BREVET EUROPEEN**

(45) Date de publication et mention de la délivrance du brevet:
**11.06.2025 Bulletin 2025/24**

(21) Numéro de dépôt: **24159484.5**

(22) Date de dépôt: **23.02.2024**

(51) Classification Internationale des Brevets (IPC):
**G01N 23/201** *(2018.01)*

(52) Classification Coopérative des Brevets (CPC):
**G01N 23/201**; H01L 22/12

(54) **PROCÉDÉ DE MESURE PAR T-SAXS D'UN DÉFAUT DE RECOUVREMENT AFFECTANT UN MOTIF DE CONTRÔLE PORTÉ PAR UN COMPOSANT MICROÉLECTRONIQUE ; SYSTÈME INSTRUMENTAL ET PRODUIT PROGRAMME D'ORDINATEUR ASSOCIÉS**

VERFAHREN ZUR T-SAX-MESSUNG EINES ABDECKUNGSFEHLERS, DER EIN DURCH EINE MIKROELEKTRONISCHE KOMPONENTE GETRAGENES KONTROLLMUSTER BEEINFLUSSEN, ENTSPRECHENDES INSTRUMENTALSYSTEM UND COMPUTERPROGRAMMPRODUKT

METHOD FOR MEASURING BY T-SAXS A COVERING DEFECT AFFECTING A CONTROL PATTERN CARRIED BY A MICROELECTRONIC COMPONENT; ASSOCIATED INSTRUMENT SYSTEM AND COMPUTER PROGRAM PRODUCT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **23.02.2023 FR 2301672**

(43) Date de publication de la demande:
**28.08.2024 Bulletin 2024/35**

(73) Titulaire: **Commissariat à l'Energie Atomique et aux Energies Alternatives
75015 Paris (FR)**

(72) Inventeurs:
• **FREYCHET, Guillaume
38054 GRENOBLE CEDEX 9 (FR)**
• **GERGAUD, Patrice
38054 GRENOBLE CEDEX 9 (FR)**

(74) Mandataire: **Lavoix
2, place d'Estienne d'Orves
75441 Paris Cedex 09 (FR)**

(56) Documents cités:
**US-A1- 2015 117 610**

• **RECHE JEROME ET AL: "Shape and Roughness Extraction of Line Gratings by Small Angle X-Ray Scattering: Statistics and Simulations", IEEE TRANSACTIONS ON SEMICONDUCTOR MANUFACTURING, IEEE SERVICE CENTER, PISCATAWAY, NJ, US, vol. 35, no. 3, 17 May 2022 (2022-05-17), pages 425 - 431, XP011916334, ISSN: 0894-6507, [retrieved on 20220518], DOI: 10.1109/TSM.2022.3176026**
• **JIANG ZHANG ET AL: "Recent advances in small angle x-ray scattering for superlattice study", APPLIED PHYSICS REVIEWS, AMERICAN INSTITUTE OF PHYSICS, 2 HUNTINGTON QUADRANGLE, MELVILLE, NY 11747, vol. 8, no. 1, 14 January 2021 (2021-01-14), XP012253027, DOI: 10.1063/5.0031692**

**Description**

La présente invention concerne un procédé de mesure d'un défaut affectant la réalisation d'un motif résultant de la superposition de deux réseaux de lignes portés par un composant microélectronique.

La présente invention concerne plus particulièrement un procédé de mesure par diffusion des rayons X aux petits angles - CD-SAXS (selon l'anglais « Critical-Dimension Small Angle X-ray Scattering ») par transmission (dénommée T-SAXS pour « transmission - Small Angle X-ray Scattering »).

La fabrication par empilement d'un composant microélectronique nécessite que les différents niveaux le constituant soient superposés avec précision, de manière à ce que les éléments portés par ces différents niveaux soient correctement positionnés les uns par rapport aux autres pour garantir le bon fonctionnement du composant final.

Il est connu de contrôler la précision de fabrication en utilisant un motif de contrôle résultant de la superposition d'un second réseau de lignes réalisé sur un second niveau du composant, au-dessus d'un premier réseau de lignes réalisé sur un premier niveau du composant. Le premier réseau de lignes, respectivement le second réseau de lignes, est par exemple gravé au cours de la réalisation des éléments du premier niveau, respectivement du second niveau.

Ce contrôle s'effectue en mesurant un défaut de recouvrement, ou « overlay » (en reprenant abusivement le terme anglais comme le ferait l'homme du métier), affectant ce motif de contrôle.

Sur ce sujet, la demanderesse a déposé la demande de brevet FR 22 02371, dans laquelle il s'agissait de mesurer l'overlay en mettant en oeuvre une technique T-SAXS.

Dans ce document, l'overlay est défini comme une translation du second réseau de lignes par rapport au premier réseau de lignes. Cette translation est caractérisée par un angle $\alpha$ entre des première et seconde directions : la première direction étant la direction normale aux lignes d'un réseau, dans le plan de ce réseau ; et la seconde direction passant par les centres géométriques des sections transversales d'une ligne du premier réseau et d'une ligne du second réseau, les lignes considérées devant être parfaitement superposées lorsque l'angle $\alpha$ est égal à 90°.

Le document US2015/117610 divulgue encore un procédé connu de mesure d'un défaut de recouvrement affectant un motif résultant de la superposition d'un premier réseau de lignes porté par un premier niveau d'un composant microélectronique et d'un second réseau de lignes porté par un second niveau du composant microélectronique par T-SAXS.

Cependant, le motif de contrôle peut être altéré d'autres façons qu'une simple translation décalant un réseau de lignes par rapport à l'autre.

Le but de la présente invention est ainsi de proposer un procédé de mesure permettant l'extraction d'une autre information sur la géométrie du motif de contrôle.

Pour cela l'invention a pour objet un procédé de mesure, un système instrumental du type T-SAXS, et un produit programme d'ordinateur selon les revendications annexées.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :

La figure 1 est une représentation schématique d'un système instrumental de mesure de l'overlay par mise en oeuvre d'une technique T-SAXS ;

La figure 2 est une représentation de la transformée de Fourier d'un motif pour lequel l'overlay est nul ;

La figure 3 est une représentation schématique de deux géométries associant déformation des lignes des deux réseaux superposées et translation des deux réseaux superposés;

La figure 4B est une simulation des facteurs de forme selon qz pour les deux formes représentées sur la figure 4A, permettant d'illustrer l'impact de la variation de l'angle $\alpha$ sur le facteur de forme, les angles $\beta 1$ et $\beta 2$ étant similaires pour ces deux formes ;

La figure 5B est une simulation des facteurs de forme selon qz pour les deux formes représentées sur la figure 5A, permettant d'illustrer l'impact de la variation des angles $\beta 1$ et $\beta 2$ sur le facteur de forme, l'angle $\alpha$ étant similaire pour ces deux formes ;

La figure 6 est une illustration de l'extraction des angles $\alpha$ et $\beta_{moy}$ respectivement à partir de la position du maximum principal et du premier maximum ; et,

La figure 7 est une représentation sous forme de blocs d'un mode de réalisation du procédé de mesure de l'overlay selon l'invention.

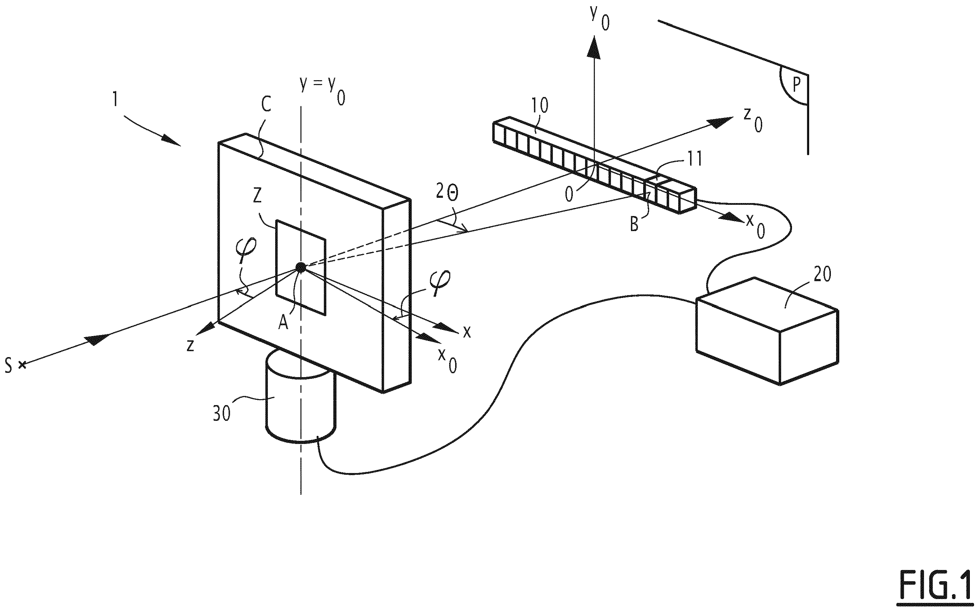

La figure 1 représente un système instrumental 1 de mesure de l'overlay.

Une source S de rayon X émet un faisceau de rayon X selon une direction $z_0$, perpendiculairement à un plan d'observation P. Le faisceau incident tombe en un point origine O du plan d'observation P. Des directions $x_0$ et $y_0$ définissent un repère orthonormal du plan P.

Un composant microélectronique C est interposé entre la source S et le plan d'observation P.

Le composant C est muni d'un motif de contrôle Z permettant la détermination de l'overlay. Le motif de contrôle Z est constitué d'un premier niveau comportant un premier réseau de lignes et, superposé au premier niveau, un second niveau comportant un second réseau de lignes.

De préférence, la surface du motif de contrôle Z affleure le reste de la surface du composant C.

Le centre A du motif de contrôle Z est placé sur l'axe d'incidence du faisceau de rayons X.

Un repère orthonormal xyz est associé au composant C. Ce repère est attaché au centre A du motif de contrôle Z de sorte que la direction y corresponde à la direction $y_0$, et que la direction z soit normale à la surface du motif de contrôle Z.

Comme précisé ci-après, les lignes des réseaux de lignes qui permettent de mesurer l'overlay sont disposées parallèlement à l'axe $y_0$, de façon à obtenir des pics de Bragg selon l'axe $x_0$.

Le composant C est placé sur un support 30 permettant de faire tourner le composant C autour de la direction y de manière à modifier l'angle d'incidence $\varphi$ du faisceau de rayons X sur le motif de contrôle Z, c'est-à-dire l'angle entre la direction z et la direction $z_0$, qui est également l'angle entre la direction x et la direction $x_0$.

Un détecteur 10 est placé dans le plan d'observation P. Il est par exemple composé d'une barrette de capteurs disposés selon la direction $x_0$.

L'intensité au point B de l'axe $x_0$, mesurée par le capteur localisé au point B, dépend de l'angle $2\theta$ entre la direction AO et la direction AB. Cette intensité est notée $I(\theta)$.

Comme connu en soi, l'image dans le plan d'observation P est en relation avec la transformée de Fourier spatiale du motif de contrôle Z éclairé par le faisceau incident.

Dans l'espace réciproque, la coordonnée associée à la direction $x_0$ est la fréquence spatiale $q_0$ définie par :

$$q_0 = \frac{2\sin(\theta)}{\lambda} \qquad\qquad (1)$$

Soit, toujours dans l'espace réciproque, mais en considérant les fréquences spatiales $q_x$ et $q_z$, respectivement associées aux directions x et z du repère lié au motif de contrôle Z :

$$q_x = q_0 \cos(\varphi) \qquad\qquad (2)$$

$$q_z = q_0 \sin(\varphi) \qquad\qquad (3)$$

Le détecteur 10 est connecté à un dispositif électronique, représenté de manière schématique sur la figure 1 par un cube portant la référence 20.

Le dispositif 20 comporte une électronique de contrôle permettant de commander le support 30 pour qu'il positionne le composant C selon une valeur de consigne de l'angle d'incidence $\varphi$.

Le dispositif 20 comporte également une électronique d'acquisition permettant d'effectuer des prétraitements adaptés sur les signaux délivrés par chacun des capteurs du détecteur 10 et à les numériser.

Le dispositif 10 comporte en outre un calculateur pour le traitement des signaux prétraités et numérisés. Le calculateur est un ordinateur comportant des moyens de calcul, tels qu'un processeur, et des moyens de mémorisation, tels qu'une mémoire. La mémoire stocke notamment les instructions de programmes d'ordinateur, en particulier un programme dont l'exécution permet la mise en oeuvre du procédé de mesure de l'overlay, c'est-à-dire d'un défaut affectant le motif de contrôle.

D'un point de vue théorique, il est possible de calculer exactement la transformée de Fourier spatiale du motif de contrôle.

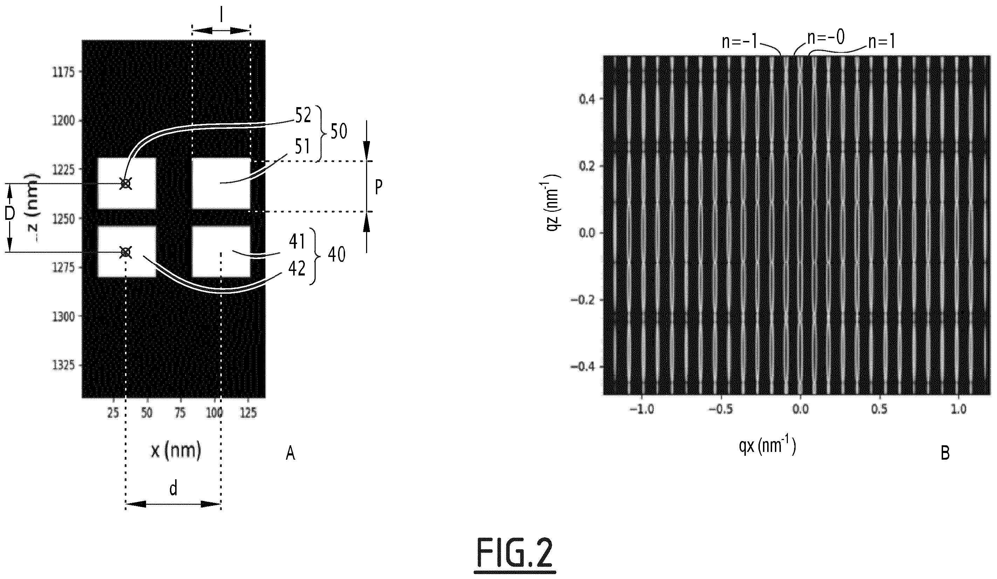

Ainsi, la partie A de figure 2 représente, dans l'espace direct des coordonnées x et z (le plan xz étant le plan transversal aux premier et second réseaux de lignes), une fraction du motif de contrôle Z porté par le composant C. Sont par exemple représentées les sections transversales de deux lignes 41 et 42 du premier réseau de lignes 40 et deux lignes 51 et 52 du second réseau de lignes 50. Les lignes de chacun de ces réseaux s'étendent selon la direction y.

Dans le cas d'un overlay nul, c'est-à-dire lorsque le motif de contrôle Z respecte une géométrie idéale, une ligne d'un réseau présente une section transversale rectangulaire, les parois latérales d'une ligne étant perpendiculaire au fond de cette ligne.

Une ligne présente une largeur l et une profondeur p.

Deux lignes d'un même réseau sont espacées d'un pas d.

Le pas entre une ligne du premier réseau et une ligne du second réseau est noté D. Ce pas selon l'épaisseur du composant est considéré comme égal à p dans la suite de la présente description (les deux réseaux étant superposés directement l'un au-dessus de l'autre), car ce pas selon l'épaisseur n'a pas d'effets mesurables sur la figure de diffraction.

Toujours selon la géométrie idéale, les premier et second réseaux de lignes sont parfaitement superposés en x, c'est-à-dire selon une direction normale aux lignes d'un réseau, dans le plan de ce réseau.

Le calcul exact de la transformée de Fourier spatiale de ce motif conduit à la partie B de la figure 2. Il s'agit d'une représentation dans l'espace réciproque des fréquences spatiales $q_x$ et $q_z$, qui sont respectivement conjuguées des coordonnées x et z.

Pour une valeur nulle de $q_z$, la transformée de Fourier présente, selon la direction $q_x$, une succession de maximums principaux, ou pic de Bragg. Chaque pic de Bragg est identifié par un entier n, dénommé ordre de Bragg. Le pic de Bragg d'ordre n est positionné en $q_x^n$.

Pour une valeur $q_x^n$ donnée, c'est-à-dire pour le pic de Bragg d'ordre n, l'intensité selon la direction $q_z$ forme ce que l'on dénomme la tige de Bragg d'ordre n. Une tige de Bragg présente une alternance de maximums et de minimums locaux.

Pour i entier supérieur à l'unité, le i$^{\text{ème}}$ maximum secondaire de la partie supérieure de la tige de Bragg d'ordre n est situé en $q_z^{n,i}$ ( $q_z^{n,i}$ positif) et le i$^{\text{ème}}$ maximum secondaire de la partie inférieure de la tige de Bragg d'ordre n est situé en $q_z^{n,-i}$ ( $q_z^{n,-i}$ négatif). On peut noter $q_z^{n,0}$ la position du maximum principal de la tige de Bragg d'ordre n.

Sur la partie B de la figure 2, la tige de Bragg d'ordre n est symétrique par rapport à l'axe $q_x$. Ainsi, la position du i$^{\text{ème}}$ maximum secondaire de la partie supérieure de la tige de Bragg d'ordre n correspond à la position du i$^{\text{ème}}$ maximum secondaire de la partie inférieure de la tige de Bragg d'ordre n : $q_z^{n,-i} = -q_z^{n,i}$.

Sur la partie B de la figure 2, on constate que, lorsqu'il n'y a pas d'overlay, la position selon l'axe $q_z$ du i$^{\text{ème}}$ maximum secondaire d'une tige de Bragg est constante, quel que soit l'ordre de Bragg n considéré ( $q_z^{n,i} = q_z^i$ ).

La présente invention permet de mesurer les paramètres d'un overlay résultant de la combinaison de deux types de défaut pouvant affecter le motif de contrôle Z de sorte qu'il s'écarte de la géométrie idéale de la figure 2 :

- une translation d'un réseau de lignes par rapport à l'autre réseau de lignes, décrit par un angle de translation $\alpha$ ; et
- une déformation des lignes des deux réseaux, décrit par un angle de déformation $\beta_{moy}$.

Le motif de contrôle Z peut présenter un défaut résultant de la translation d'un réseau de lignes par rapport à l'autre selon une direction normale aux lignes d'un réseau, dans le plan de ce réseau.

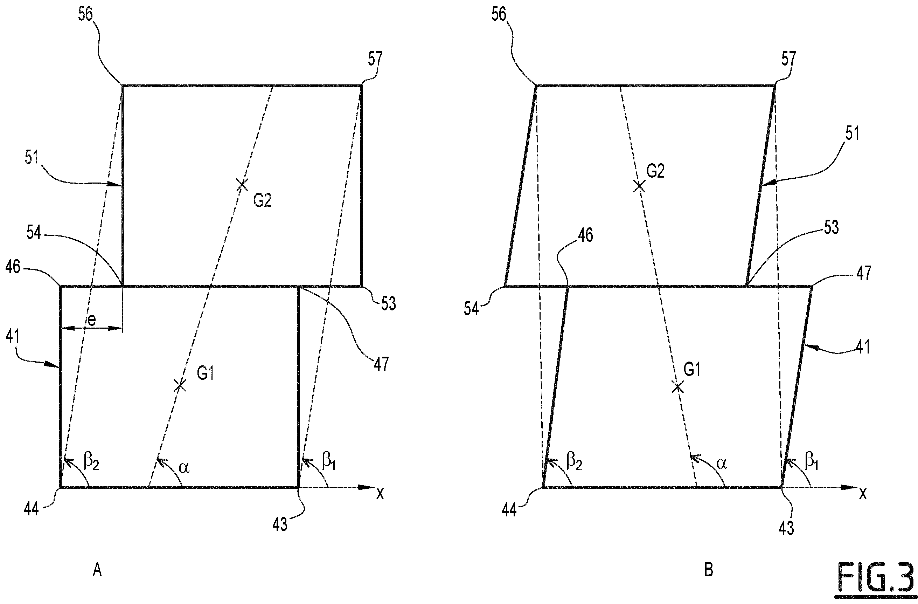

Par exemple, sur la partie 1 de la Figure 3, la ligne supérieure 51 est translatée selon la direction x d'une distance e par rapport à la ligne inférieure 41.

Cet premier type de défaut (ou d'overlay) est décrit par l'angle $\alpha$, ou angle de translation, entre la direction normale x et la direction reliant les centres géométriques $G_1$ et $G_2$ d'une paire de lignes.

Le motif de contrôle peut également présenter un défaut résultant de la déformation des lignes des réseaux de lignes, chaque ligne ayant alors une section en losange (dit autrement, les parois latérales d'une ligne ne sont plus à angle droit par rapport au fond de cette ligne).

Par exemple, sur la partie B de la Figure 3, les bords entre les coins 44 et 46, d'une part, et 43 et 44, d'autre part, de la ligne inférieure 41 sont inclinés, et les bords entre les coins 54 et 56, d'une part, et 53 et 54, d'autre part, de la ligne supérieure 51 sont inclinés.

On définit un premier angle de bord $\beta_1$ comme l'angle entre la direction x et la direction joignant le coin inférieur droit 43 de la première ligne 41 et le coin supérieur droit 57 de la seconde ligne 51.

On définit un second angle de bord $\beta_2$ comme l'angle entre la direction x et la direction joignant le coin inférieur gauche 44 de la première ligne 41 et le coin supérieur gauche 56 la seconde ligne 51.

L'angle de déformation $\beta_{moy}$ caractérisant ce second type de défaut (ou d'overlay) est alors défini comme la moyenne des premier et second angles de bord : $\beta_{moy} = \frac{\beta_1 + \beta_2}{2}$ .

Dans le cas où le motif est affecté par un défaut de translation mais pas par un défaut de déformation (partie A de la Figure 3), on montre que $\beta_{moy} = \alpha$, de sorte que ces deux paramètres permettent alors d'extraire la même information sur la géométrie du motif.

En revanche, lorsque le motif est affecté par un défaut de translation et par un défaut de déformation (partie B de la Figure 3), on perd l'égalité $\beta_{moy} = \alpha$, et les deux paramètres $\beta_{moy}$ et $\alpha$ permettent alors d'extraire une information différente sur l'overlay.

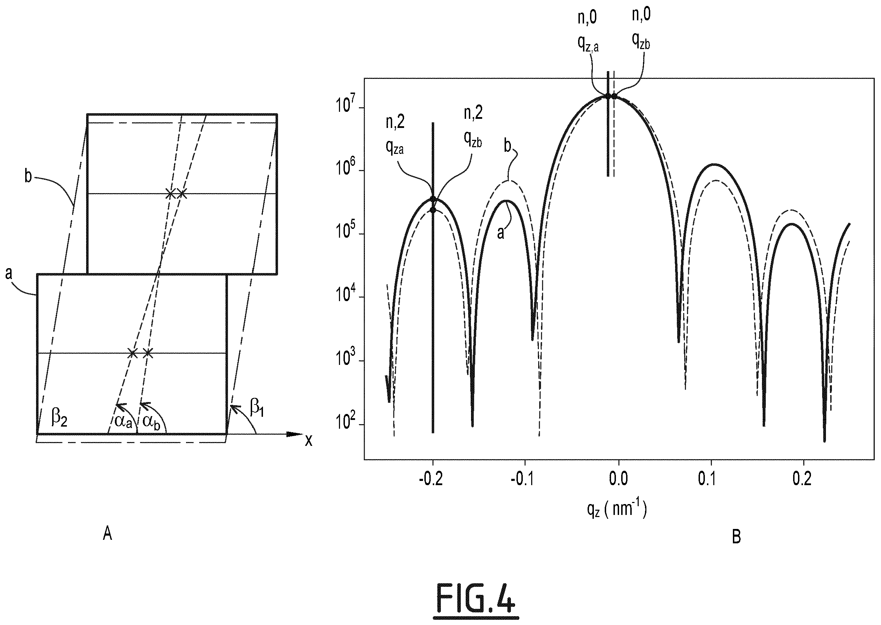

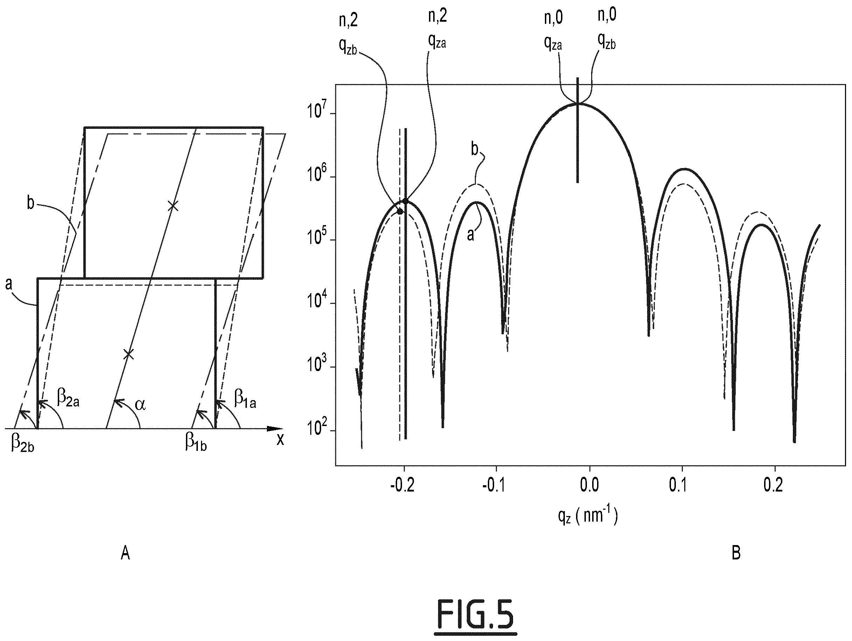

Les figures 4 et 5 permettent de montrer que les deux paramètres $\beta_{moy}$ et $\alpha$ sont indépendants l'un de l'autre et peuvent être extraits d'une figure de diffraction indépendamment l'un de l'autre.

Sur la partie A de la Figure 4, deux motifs sont superposés avec des overlays différents.

Le motif a, représenté en traits pleins, correspond à un overlay causé uniquement par une translation. Le motif b, représenté en traits pointillés, correspond à un overlay causé, non seulement par une translation, mais également par une déformation des lignes. Ces deux motifs présentent des valeurs différentes de l'angle $\alpha$ (respectivement $\alpha_a$ et $\alpha_b$), mais des valeurs identiques de l'angle $\beta_{moy}$.

Sur la partie B de la Figure 4, sont représentées les tiges de Bragg d'un même ordre n pour chacun des deux motifs a et b de la partie A de la Figure 4.

On constate que la position du maximum principal de l'intensité n'est plus identique pour les deux motifs ( $q_{az}^{n,0} \neq q_{bz}^{n,0}$ ), et que les positions des maximums secondaires de l'intensité sont identiques ( $q_{az}^{n,2} = q_{bz}^{n,2}$ pour le second maximum secondaire par exemple).

Sur la partie A de la Figure 5, deux motifs sont superposés.

Le motif a, représenté en traits pleins, correspond à un overlay causé uniquement par une translation. Le motif b, représenté en traits pointillés, correspond à un overlay causé non seulement par une translation, mais également par une déformation des bords des lignes.

Ces deux motifs présentent des valeurs identiques de l'angle $\alpha$, mais des valeurs différentes de l'angle $\beta_{moy}$ (respectivement $\beta_{moya}$ et $\beta_{moyb}$)

Sur la partie B de la Figure 5, sont représentées les tiges de Bragg d'un même ordre n pour chacun de ces deux motifs.

On constate que si la position du maximum principal de l'intensité est identique pour les deux motifs a et b ( $q_{az}^{n,0} = q_{bz}^{n,0}$ ), il existe maintenant un décalage entre les positions des maximums secondaires de l'intensité ( $q_{az}^{n,2} \neq q_{bz}^{n,2}$ ).

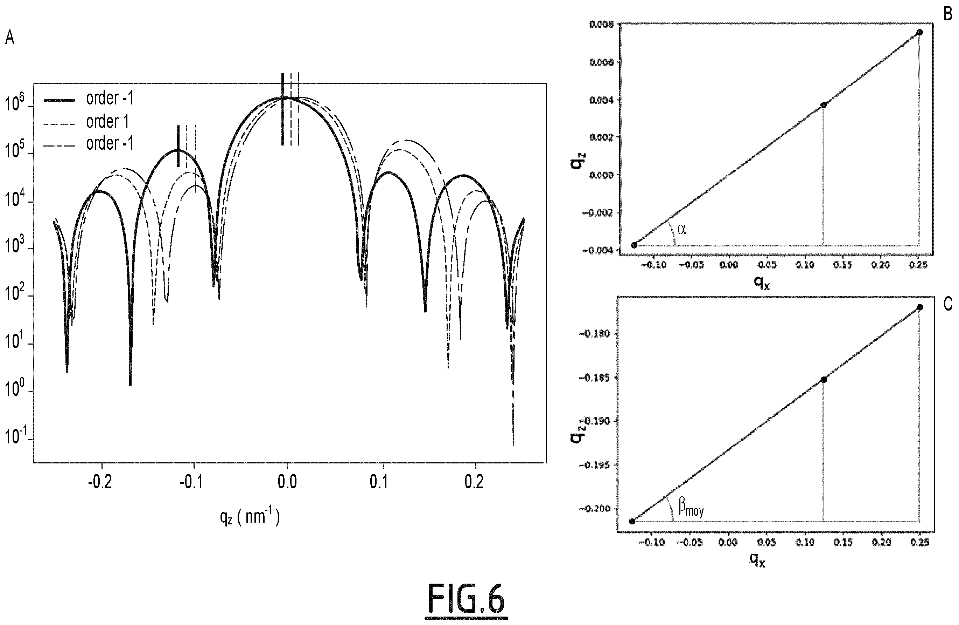

La partie 1A de la Figure 6 représente, pour un même motif affecté par un défaut de translation et un défaut de déformation, différentes tiges de Bragg, en l'occurrence les tiges d'ordre -1, 1 et 2.

Les mesures effectuées sur les positions des maximums principaux des différentes tiges de Bragg permettent d'établir une relation linéaire entre la position de ces maximums dans le plan $q_z$ et $q_x$ (partie B de la Figure 6).

Ainsi, l'angle $\alpha$ peut s'exprimer de la façon suivante :

$$\tan(\alpha) = \frac{\Delta q_z^0}{\Delta q_x}$$

Avec $\Delta q_z^0 = q_z^{n,0} - q_z^{m,0}$ et $\Delta q_x = q_x^n - q_x^m$, où n et m sont les ordres des tiges de Bragg utilisées pour l'extraction d'information sur l'overlay.

Les mesures effectuées sur les positions des maximums secondaires des différentes tiges de Bragg permettent d'établir une relation linéaire entre la position de ces maximums dans le plan $q_z$ et $q_x$ (partie C de la Figure 6).

Ainsi, l'angle $\beta_{moy}$ peut s'exprimer de la façon suivante :

$$\tan\left(\beta_{moy}\right) = \frac{\Delta q_z^i}{\Delta q_x}$$

Avec $\Delta q_z^i = q_z^{n,i} - q_z^{m,i}$ et $\Delta q_x = q_x^n - q_x^m$, où n et m sont les ordres des tiges de Bragg utilisées pour l'extraction et i le ième maximum secondaire considéré.

Des vérifications montrent une très bonne adéquation de ces relations avec les angles réels.

Par conséquent, en mesurant deux ordres de diffraction n et m, quel qu'ils soient, le décalage observé sur le maximum principal, ainsi que sur un maximum secondaire permet l'extraction à la fois de l'angle $\alpha$ et de l'angle $\beta_{moy}$, ces deux paramètres permettant une description de la forme des lignes et donc de l'overlay.

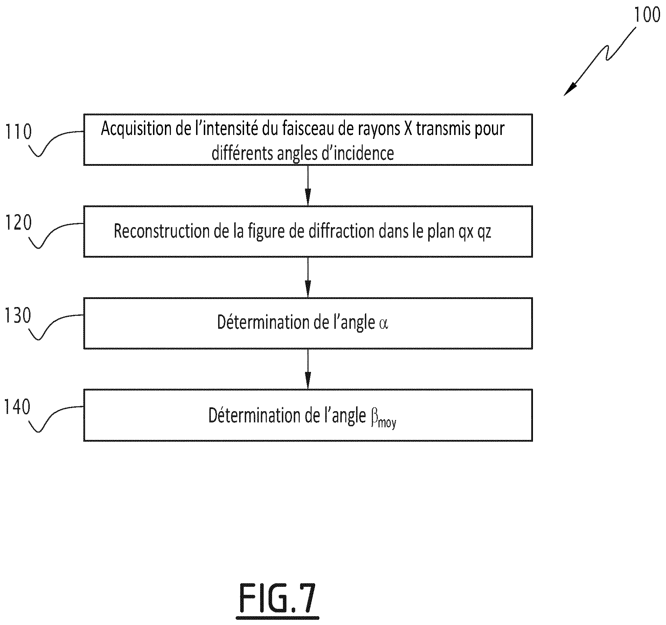

Compte tenu de ces considérations, un mode de réalisation du procédé de mesure de l'overlay selon l'invention va maintenant être présenté en référence à la Figure 7.

Le procédé 100 consiste d'abord à reconstruire au moins deux tiges de Bragg d'intérêt, par exemple les ordres n et m.

Pour cela, dans une première étape 110 d'acquisition, au moyen du détecteur 10, on itère la mesure de l'intensité pour différents angles d'incidence $\varphi$. Par exemple, on fait varier l'angle d'incidence par pas de 1° dans la plage de +60° à -60° et pour chaque valeur de l'angle d'incidence on mesure l'intensité en fonction de la position le long de l'axe $x_0$ du plan d'observation P, c'est-à-dire en fonction de l'angle de diffraction $\theta$.

Puis, dans une étape 120, on reconstruit la figure de diffraction dans l'espace réciproque décrit par les coordonnées $q_x$ et $q_z$.

Une fois les tiges de Bragg d'intérêt reconstruites, le procédé 100 se poursuit par une étape 130 de détermination de l'angle $\alpha$ :

- on calcule d'abord : $\Delta q_x = q_x^n - q_x^m$ ;

- on calcule ensuite : $\Delta q_z^0 = q_z^{n,0} - q_z^{m,0}$

- et finalement on détermine l'angle de translation : $\alpha = \arctan(\frac{\Delta q_z^0}{\Delta q_x})$

Le procédé 100 se poursuit par une étape 140 de détermination de l'angle $\beta_{moy}$ :

- on reprend la valeur de $\Delta q_x$ calculée précédemment ;

- on calcule ensuite : $\Delta q_z^i = q_z^{ni} - q_z^{m,i}$  (par exemple i est égal à 2) ;

- et finalement on détermine l'angle de déformation: $\beta_{moy} = \arctan(\frac{\Delta q_z^i}{\Delta q_x})$ .

La présente invention permet de mesurer les paramètres caractéristiques des défauts de translation et de déformation affectant potentiellement un motif.

Dans la présente description, on s'est attaché à un motif de contrôle, réalisé spécifiquement sur le composant pour effectuer des mesures de la qualité de la fabrication. Cependant, en variante, le motif peut être élaboré à partir d'éléments fonctionnels du composant, comme par exemple des lignes de transistors appartenant à des niveaux différents du composant.


**Revendications**

1.  Procédé (100) de mesure d'un défaut de recouvrement affectant un motif résultant de la superposition d'un premier réseau de lignes (40) porté par un premier niveau d'un composant microélectronique (C) et d'un second réseau de lignes (50) porté par un second niveau du composant microélectronique, un repère orthonormé xyz étant associé au composant microélectronique, les lignes des premier et second réseaux de lignes étant orientées selon la direction y, et les premier et second réseaux de lignes étant superposés selon la direction z, le procédé de mesure mettant en oeuvre une technique de diffusion des rayons X aux petits angles par transmission (T-SAXS), comportant

    les étapes de :

    - acquérir (110), en éclairant le motif, une pluralité de mesures d'intensité d'un faisceau de rayons X transmis pour une pluralité d'angles d'incidence du faisceau de rayons X, l'angle d'incidence étant défini comme l'angle, évalué dans le plan défini par les directions x et z, entre la direction z et la direction d'incidence du faisceau de rayons X ;
    - reconstruire (120), à partir de la pluralité de mesures d'intensité, au moins deux tiges de Bragg d'intérêt d'une figure de diffraction selon des fréquences spatiales $q_x$ et $q_z$, associées respectivement aux directions x et z ;

    **caractérisé en ce que** le procédé comporte les étapes de:

    - déterminer (130) un angle de translation à partir d'un écart entre les positions selon la direction $q_z$ des maximums principaux des deux tiges de Bragg ; et/ou,
    - déterminer (140) un angle de déformation à partir d'un écart entre les positions selon la direction $q_z$ des i$^{ème}$ maximums secondaires des deux tiges de Bragg,

    l'angle de translation étant l'angle $\alpha$ défini entre la direction x et la direction reliant les centres géométriques des sections transversales d'une ligne du premier réseau de lignes et d'une ligne correspondante du second réseau de lignes et l'étape de détermination de l'ange de translation utilisant la relation :

$$\alpha = \arctan(\frac{\Delta q_z^0}{\Delta q_x})$$

où $\Delta q_x = q_x^n - q_x^m$ et $\Delta q_z^0 = q_z^{n,0} - q_z^{m,0}$, m et n étant les ordres respectifs des deux tiges de Bragg reconstruites,

l'angle de déformation étant l'angle $\beta_{moy}$ défini comme la moyenne entre un premier angle de bord et un second angle de bord, le premier angle de bord étant l'angle entre la direction x et la direction joignant le coin inférieur droit d'une ligne du premier réseau de lignes et le coin supérieur droit de la ligne correspondante du second réseau de lignes et le second angle de bord étant l'angle entre la direction x et la direction joignant le coin inférieur gauche d'une ligne du premier réseau de lignes et le coin supérieur gauche de la ligne correspondant du second réseau de lignes et l'étape de détermination de l'ange de déformation utilisant la relation :

$$\beta_{moy} = \arctan(\frac{\Delta q_z^i}{\Delta q_x})$$

où $\Delta q_x = q_x^n - q_x^m$ et $\Delta q_z^i = q_z^{n,i} - q_z^{m,i}$, m et n étant les ordres respectifs des deux tiges de Bragg reconstruites.

2. Système instrumental (1) du type par diffusion des rayons X aux petits angles par transmission (T-SAXS), comportant un détecteur, une électronique d'acquisition et un calculateur, **caractérisé en ce que** le calculateur est convenablement programmé pour que ledit système instrumental mette en oeuvre un procédé de mesure d'un défaut de recouvrement selon la revendication 1.

3. Système instrumental selon la revendication 2, comportant un détecteur adapté pour mesurer l'intensité du faisceau transmis sur une plage d'angle de diffraction réduite permettant de suivre les aux moins deux tiges de Bragg d'intérêt au cours de l'étape d'acquisition.

4. Produit programme d'ordinateur comportant des instructions logicielles qui, lorsqu'elles sont exécutées par un calculateur d'un système instrumental conforme à l'une quelconque des revendication 2 et 3 permet à ce dernier de mettre en oeuvre un procédé de mesure d'un défaut de recouvrement selon la revendication 1.

**Patentansprüche**

1. Verfahren (100) zur Messung eines Abdeckungsfehlers, der ein Muster beeinflusst, das aus der Überlagerung eines ersten Liniennetzes (40), das von einer ersten Ebene einer mikroelektronischen Komponente (C) getragen wird, und eines zweiten Liniennetzes (50), das von einer zweiten Ebene der mikroelektronischen Komponente getragen wird, resultiert, wobei ein orthonormales Koordinatensystem xyz mit der mikroelektronischen Komponente assoziiert ist, wobei die Linien des ersten und des zweiten Liniennetzes in y-Richtung ausgerichtet sind und das erste und das zweite Liniennetz in z-Richtung überlagert sind, wobei das Messverfahren eine Kleinwinkel-Röntgenstreuungstechnik durch Transmission (T-SAXS) durchführt, umfassend

   die folgenden Schritte:

   - Erfassen (110), durch Beleuchten des Musters, einer Vielzahl von Intensitätsmessungen eines übertragenen Röntgenstrahls für eine Vielzahl von Einfallswinkeln des Röntgenstrahls, wobei der Einfallswinkel definiert ist als der Winkel, bewertet in der Ebene, die durch die x- und die z-Richtung definiert ist, zwischen der z-Richtung und der Einfallsrichtung des Röntgenstrahls;
   - Rekonstruieren (120), anhand der Vielzahl von Intensitätsmessungen, von mindestens zwei Bragg-Stäben von Interesse eines Beugungsmusters gemäß räumlichen Frequenzen $q_x$ und $q_z$, die jeweils mit der x- und der z-Richtung assoziiert sind;

   **dadurch gekennzeichnet, dass** das Verfahren die folgenden Schritte umfasst:

   - Bestimmen (130) eines Translationswinkels anhand einer Abweichung zwischen den Positionen entlang der $q_z$-Richtung der Hauptmaxima der zwei Bragg-Stäbe; und/oder

- Bestimmen (140) eines Verformungswinkels anhand einer Abweichung zwischen den Positionen entlang der $q_z$-Richtung der i-ten Sekundärmaxima der zwei Bragg-Stäbe,

wobei der Translationswinkel der Winkel $\alpha$ ist, der zwischen der x-Richtung und der Richtung definiert ist, die die geometrischen Zentren der Querschnitte einer Linie des ersten Liniennetzes und einer entsprechenden Linie des zweiten Liniennetzes verbindet, und wobei der Schritt eines Bestimmens des Translationswinkels die folgende Beziehung verwendet:

$$\alpha = arctan\left(\frac{\Delta q_z^0}{\Delta q_x}\right)$$

wobei $\Delta q_x = q_x^n - q_x^m$ und $\Delta q_z^0 = q_z^{n,0} - q_z^{m,0}$, m und n die jeweiligen Ordnungen der zwei rekonstruierten Bragg-Stäbe sind,

wobei der Verformungswinkel der Winkel $\beta_{Mittelwert}$ ist, der als Mittelwert zwischen einem ersten Randwinkel und einem zweiten Randwinkel definiert ist, wobei der erste Randwinkel der Winkel zwischen der x-Richtung und der Richtung ist, die die rechte untere Ecke einer Linie des ersten Liniennetzes und die rechte obere Ecke der entsprechenden Linie des zweiten Liniennetzes verbindet, und der zweite Randwinkel der Winkel zwischen der x-Richtung und der Richtung ist, die die linke untere Ecke einer Linie des ersten Liniennetzes und die linke obere Ecke der entsprechenden Linie des zweiten Liniennetzes verbindet, und der Schritt eines Bestimmens des Verformungswinkels die folgende Beziehung verwendet:

$$\beta_{Mittelwert} = arctan\left(\frac{\Delta q_z^i}{\Delta q_x}\right)$$

wobei $\Delta q_x = q_x^n - q_x^m$ und $\Delta q_z^i = q_z^{n,i} - q_z^{m,i}$, m und n die jeweiligen Ordnungen der zwei rekonstruierten Bragg-Stäbe sind.

2. Instrumentensystem (1) vom Typ Kleinwinkel-Röntgenstreuung durch Transmission (T-SAXS), umfassend einen Detektor, eine Erfassungselektronik und einen Rechner, **dadurch gekennzeichnet, dass** der Rechner auf geeignete Weise programmiert ist, damit das Instrumentensystem ein Verfahren zum Messen eines Abdeckungsfehlers nach Anspruch 1 durchführt.

3. Instrumentensystem nach Anspruch 2, umfassend einen Detektor, der angepasst ist, um die Intensität des übertragenen Strahls über einen reduzierten Beugungswinkelbereich zu messen, der es ermöglicht, die mindestens zwei Bragg-Stäbe von Interesse während des Erfassungsschritts zu verfolgen.

4. Computerprogrammprodukt, umfassend Softwareanweisungen, die, wenn sie von einem Rechner eines Instrumentensystems nach einem der Ansprüche 2 und 3 ausgeführt werden, es diesem ermöglichen, ein Verfahren zum Messen eines Abdeckungsfehlers nach Anspruch 1 durchzuführen.

## Claims

1. A method (100) for measuring a defect of overlay affecting a pattern resulting from the superposition of a first array of lines (40) carried by a first level of a microelectronic component (C) and of a second array of lines (50) carried by a second level of the microelectronic component, an orthonormal xyz marker being associated with the microelectronic component, the lines of the first and second arrays of lines being oriented along the direction y, and the first and the second arrays of lines being superimposed along the direction z, the measurement method using the small angle X-ray scattering technique (T-SAXS) including

the steps of:

- acquiring (110), by illuminating the pattern, a plurality of intensity measurements of a transmitted X-ray beam for a plurality of angles of incidence of the X-ray beam, the angle of incidence being defined as the angle, evaluated in the plane defined by the directions x and z, between the direction z and the direction of incidence of the X-ray beam;

- reconstructing (120), from the plurality of intensity measurements, at least two Bragg rods of interest of a diffraction pattern according to spatial frequencies $q_x$ and $q_z$ associated with the directions x and z, respectively;

**characterized in that** the method includes the steps of:

- determining (130) an angle of translation from a deviation between the positions along the direction $q_z$ of the principal maxima of the two Bragg rods; and/or,
- determining (140) an angle of deformation from a deviation between the positions along the direction $q_z$ of the $i^{th}$ secondary maxima of the two Bragg rods,

the angle of translation being the angle $\alpha$ defined between the direction x and the direction connecting the geometric centers of the cross-sections of a line of the first array of lines and a corresponding line of the second array of lines and the step of determining the angle of translation using the relation

$$\alpha = arctan\left(\frac{\Delta q_z^0}{\Delta q_x}\right)$$

where $\Delta q_x = q_x^n - q_x^m$ and $\Delta q_z^0 = q_z^{n,0} - q_z^{m,0}$ m and n are the respective orders of the two reconstructed Bragg rods,

the deformation angle being the angle $\beta_{mean}$ defined as the average between a first edge angle and a second edge angle, the first edge angle being the angle between the direction x and the direction joining the lower right corner of a line of the first array of lines and the upper right corner of the corresponding line of the second array of lines, and the second edge angle being the angle between the direction x and the direction joining the lower left corner of a line of the first array of lines and the upper left corner of the corresponding line of the second array of lines and the step of determining the angle of deformation using the relation:

$$\beta_{mean} = arctan\left(\frac{\Delta q_z^i}{\Delta q_x}\right)$$

where $\Delta q_x = q_x^n - q_x^m$ and $\Delta q_z^i = q_z^{n,i} - q_z^{m,i}$, m and n being the respective orders of the two reconstructed Bragg rods.

2. A small angle X-ray scattering T-SAXS instrument system (1), including a detector, acquisition electronic elements and a computer, **characterized in that** the computer is suitably programmed so that said instrument system implements a method for measuring a defect of overlay according to claim 1.

3. The instrument system according to claim 2, including a detector suitable for measuring the intensity of the beam transmitted over a reduced range of angles of diffraction making it possible to follow the at least two Bragg rods of interest during the acquisition step.

4. A computer program product including software instructions which, when executed by a computer of an instrument system according to any one of claims 2 and 3, enable the latter to implement a method for measuring a defect of overlay according to claim 1.

EP 4 421 482 B1

FIG.1

**FIG.2**

A

B

EP 4 421 482 B1

FIG.3

FIG.4

FIG.5

EP 4 421 482 B1

EP 4 421 482 B1

FIG.6

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2202371

- US 2015117610 A